# EUROPEAN PATENT APPLICATION

(11) **EP 1 670 068 A1**
(43) Date of publication of application: **14.06.2006**
(21) Application number: 04029194.0
(22) Date of filing: 09.12.2004
(51) Int. Cl.: H01L 33/00

(54) **Manufacturing method and device for white light emitting**

(71) Applicant: SuperNova Optoelectronics Corporation, Ping Cheng City Taoyuan County 324 (TW)
(72) Inventor: Mu-Jen, Lai, Chungli City Tao Yuan Hsien (TW); Hon, Schang-Jing, Pa Te City Tao Yuan Hsien (TW)
(74) Representative: Kador & Partner

(57) **Abstract**

A manufacturing method and device for white light emitting comprise at least two light emitting layers capable of emitting the light with the wavelengths of λ1 and λ2. Upon absorbing the light with the wavelength of one light emitting layer by at least one kind of fluorescent material, the light with the wavelength of λ3 is emitted and then mixed together with the light with the other wavelength so as to output the white light for use. Then, the fluorescent material formed on the light emitting layer of the light emitting device is packed together with said light emitting device, and then the assembly is the white light emitting device with high color rendering index of this invention.

## Description

### Background of the Invention

### Field of the Invention

The present invention relates to a white light emitting device and its manufacturing method, especially a kind of white light emitting device, which can emit white light. Therein, at least two light emitting layers of light emitting device and one fluorescent material are utilized. By the fluorescent material absorbing part of the light of one from the light emitting layers and then transfers into another light , mixed with the light of the light emitting layer and fluorescent so as to finish the white light emitting device with high color rendering.

### Description of the Related Art

Accordingly, the light emitting diode (LED), belonging to luminescent emission, is a kind of solid semiconductor components, which utilizes the recombination of the two apart carriers (i.e., the electron and hole) to produce the light. Different from the heat illuminating of the tungsten electric light bulb, only the slight current, which is connected to the two sides of the light emitting diode, is needed to produce the light. Because of the various used materials of the LED, the inner electron and hole occupy different energy levels. The energy level would influence the energy of the combined photons and contribute to the light of different wavelengths (e.g., different colors of light such as red, orange, yellow, green, blue, or invisible light, etc.) The advantages of the LED products include long life, energy-saving, durability, resistance to vibration, reliability, suitability for mass production, compactness, and flexibility.

The LED is classified into visible and invisible lights. Therein, the visible light emitting diode products include red, yellow, orange and etc. with the applications such as the back light source, the keypad, the PDA back light source, the indicators of information and consumer-electronics, industrial panel apparatus, indicator motor panel and brakelight, billboard, traffic signals and etc. As to the invisible light LED products including IrDA, VCSEL, LD and so on are mainly applied in communication, which is classified into two areas. The infra-red light of short wavelength is applied in wireless communication such as IrDA molding, remote controller, sensor and the infra-red of long wavelength is used in the communicating light source of short distance.

As to the present applications of white light emitting diode, in the aspect of illuminating, the main usages are the lamp for reading in the car, decorative lamp, and so on, and the other usages nearly 95% are the back light source of LCD dominantly with compact dimensions because of the questions about the light emitting efficiency and the life. From the aspect of application, the perspectives are prosperous for the back light source of the screen of the colorful cell phones and the cell phones with the accessory of flash light of the digital camera in the white light emitting diode market next year. Then, the target of white light emitting diode is focused on the back light source of large dimension and the substitute market of global illumination.

The blue light LED with high luminance and the white light LED made of fluorescent materials (YAG:Ce) are considered as the energy-saving light source of the new generation. In addition, the UV LED and the white light emitting diode made of fluorescent material with three wavelengths are also included in the new generation.

As the disclosure of United State Patent No. 5,998,925, the hybrid LED was formed by packing the GaN chip and the yttrium-aluminum-garnet fluorescent material (YAG) together. The YAG fluorescent material, which was constituted by high temperature, with Ce³⁺ was activated by the blue light, emitted by the GaN chip ( λ ₚ=400~530nm ' Wd=30nm) , and then emitted the yellow light with the peak value of 550nm. The blue light emitting diode chip was installed in the cup reflecting recess and covered with the resin with the YAG mixed around 200-500nm. A part of the emitted blue light of the LED chip was absorbed by the YAG fluorescent material and the other part was mixed with the yellow light emitted by the YAG fluorescent material, then generating the white light.

However, in such kind of conventional art, to prompt the red light part to achieve the high rendering index, it's inevitable to increase the gadolinium (Gd) content of the yttrium-aluminum-garnet series chemical compound, but at the same time, the light conversion efficiency of the YAG fluorescent material would also decrease as the increasing of the gadolinium(Gd) content. Therefore, in the conventional art, to obtain the white light of high rendering index, the illumination efficiency would also lower at the same time. Moreover, as the disclosure of United State Patent No. 6,084,250, wherein the white light emitting device can be made by mixing the LED capable of emitting the UV light with the three fluorescent materials capable of absorbing the UV light and emitting the R.G.B. lights respectively. However, until now, the light conversion efficiencies of the fluorescent materials capable of UV light absorption are all poor than the yttrium-aluminum-garnet fluorescent materials. Thus, to achieve pragmatism, it's necessary to invent a more efficient UV light emitting diode.

Furthermore, a kind of hybrid light emitting diode, disclosed in Taiwan gazette No. 546852, therein there is only a tunneling barrier layer needed between the two light emitting layers under the unchanged composition and structure of the first and second light emitting layers with the fixed wavelengths of two main emission peaks. The population ratio of the conductive carriers, involved in the light-electricity conversion between the two light emitting areas, can be altered and then change the relative illuminating intensity via changing the tunneling probability of the conductive carriers in the tunneling barrier layer by adjusting the width of the tunneling barrier layer. Therefore, the monolithic can emit the mixed light or white light with specific chromaticity via the mixing of the lights of the first light emitting layer of the first wavelength and the second light emitting layer of the second wavelength. The color of the mixed light can be altered only through changing the width of the tunneling barrier layer so as to simplify the manufacturing process of the hybrid light emitting diode. However, even in the theory aspect, the disclosed structure of this invention is viable, from the power-saving purpose, there is still a shortcoming about the rising operating voltage of the device caused by the formed tunneling barrier layer between the two light emitting layers.

Hence, to propose solution of a creative white light emitting diode and manufacturing method to the afore-mentioned problem has been the consistent expectation and concern of the inventor. Based on the engagement in the research, development, and practical sales experience on the related products for many years, the idea of invention has been in embryo, and finally, a kind of white light emitting device and the improved manufacturing method has been figured out via the dedicated personal professional knowledge, study design, and seminars.

### Summary of the Invention

The purpose of the present invention is to offer a white light emitting device and manufacturing method, wherein includes a light emitting component and at least two fluorescent material. The light emitting component include two or more light emitting layers which include the lights of wavelengths of λ 1 and λ 2. And the fluorescent material is capable of absorbing one of the wavelength of light emitting layers and emitting the wavelength of λ 3. The emitted light is then mixed with the light of another two wavelengths, thus generating a white light emitting device with high rendering index, high efficiency, and energy saving.

Another purpose of this invention is to disclose a white light emitting device and the manufacturing method, including a light emitting component and at least two different kind of fluorescent materials. The light emitting component includes two or more light emitting layers with the light of wavelengths of λ 1 and λ 2 and the fluorescent materials could absorb one of the wavelength respectively and emitting the lights of λ 3 and λ 4 respectively. The emitted light is then mixed with the lights of other different wavelength, thus contributing to a white light emitting device with high rendering index, high efficiency, and power saving.

The third purpose of this invention is to offer a white light emitting device and manufacturing method, wherein the disclosed light emitting device is capable of emitting blue and orange-red lights. And then one or more fluorescent material is utilized to absorb the blue light and emit the yellow-green light so as to generate the white light by mixing the blue, yellow-green, and orange-red lights.

The last purpose of this invention is to offer a white light emitting device and the manufacturing method, wherein the disclosed light emitting device is capable of emitting UV light and blue light. And then, at least one of the fluorescent materials is used to absorb the blue light and emit yellow-green light, and at least another one of the fluorescent materials is used to absorb the UV light and emit the red light so as to mix the blue, yellow-green, and red lights and generate the white light.

To achieve the above-mentioned purposed and functions, this invention is to disclose a white light emitting device and manufacturing method, wherein the disclosed light emitting device comprises at least two light emitting layers, which are formed on the N-type ohmic contact layer. Following, the P-type ohmic contact layer is formed on the two or more light emitting layers and then constitutes the light emitting device with at least two light emitting layers. Subsequently, the fluorescent material is applied on the light emitting path of the light emitting device to fabricate the white light emitting device of this invention.

### Brief Description of the Drawings

Fig. 1 is the preferred embodiment of the white light emitting device manufacturing process of this invention.

Fig. 2 A is the preferred embodiment of the first light emitting layer manufacturing process of this invention.

Fig. 2 B is the preferred embodiment of the second light emitting layer manufacturing process of this invention.

Fig. 3 A is the preferred embodiment of the light emitting device with at least two light emitting layers of this invention.

Fig. 3 B is the preferred embodiment of the white light emitting device of this invention.

Fig. 4 is the preferred embodiment of the light emitting layer structure of the white light emitting device of this invention.

Fig. 5 is the preferred embodiment of the simple energy band formed of the first orange-red light emitting layer and the second blue light emitting layer.

Fig. 6 A is the preferred embodiment of light emitting spectrum at the driving current of 20 mA imposed on the P-type electrode and the N-type electrode of this invention.

Fig. 6 B is the preferred embodiment of mixed white light emitting spectrum at the driving current of 20 mA imposed on the white light emitting device of this invention.

Fig. 7 is the preferred embodiment of the simple energy band formed of the first blue light emitting layer and the second UV light emitting layer of this invention.

Fig. 8 A is the preferred embodiment of the light emitting spectrum at the driving current of 20 mA imposed on the P-type electrode and N-type electrode of this invention.

Fig. 8 B is the preferred embodiment of the mixed white light emitting spectrum at the imposed driving current of 20 mA.

### Detailed Description of the Preferred Embodiment

To have a further understanding about the features of the structure and the achieved effects, of the present invention, the preferred embodiment and detailed description are unfolded as following.

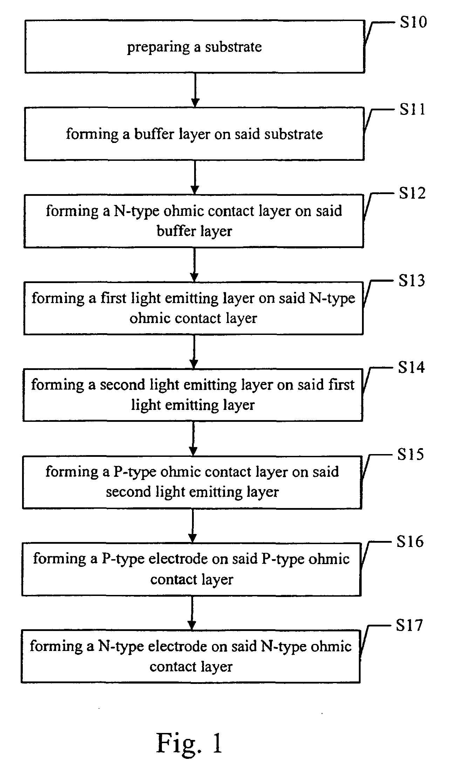

First of all, the Fig. 1 depicts a preferred embodiment of a kind of white light emitting device and the manufacturing this invention. As shown on the figure, the main procedure of the white light emitting device manufacturing method of this invention comprises:
- Step S 10:: preparing a substrate.
- Step S11:: forming a buffer layer on said substrate
- Step S12:: forming a N-type ohmic contact layer on said buffer layer.
- Step S 13:: forming a first light emitting layer on said N-type ohmic contact layer.
- Step S 14:: forming a second light emitting layer on said first light emitting layer.
- Step S15:: forming a P-type ohmic contact layer on said second light emitting layer.
- Step S16:: forming a P-type electrode on said P-type ohmic contact layer, and
- Step S17:: forming a N-type electrode on said N-type ohmic contact layer.

Wherein, the above-mentioned steps have constituted a LED chip, and the fluorescent material is then installed on the light emitting direction of the LED chip by conventional package methode.

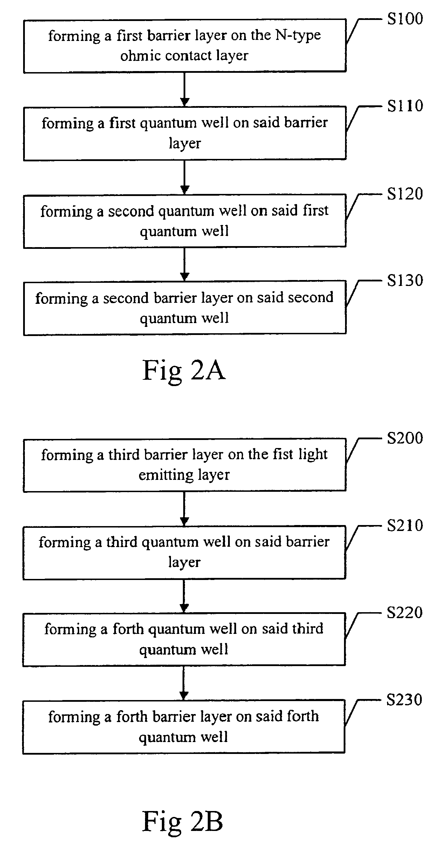

Furthermore, the light emitting layer manufacturing method as mentioned in step S13 is depicted as Fig. 2A shown the first light emitting layer manufacturing procedure of the preferred embodiment of this invention. As shown in the figure, the main procedure comprises:
- Step S100:: forming a first barrier layer on the N-type ohmic contact layer.
- Step S110:: forming a first quantum well on said barrier layer.
- Step S 120:: forming a second quantum well on said first quantum well, and
- Step S130:: forming a second barrier layer on said second quantum well.

Therein, duplicate step S110 on the second barrier layer, step S120, and step S130 to form a first light emitting layer of multi quantum well structure.

Additionally, the second light emitting layer manufacturing method of step S14 is depicted as fig. 2B, which is the preferred embodiment of the second light emitting layer manufacturing procedure of this invention. As the depiction of the figure, the main procedure comprises:
- Step S200:: forming a third barrier layer on the fist light emitting layer.
- Step S210:: forming a third quantum well on said barrier layer.
- Step S220:: forming a forth quantum well on said third quantum well, and
- Step S230:: forming a forth barrier layer on said forth quantum well.

Wherein, duplicate step S210, formed on the forth barrier layer, step S220, and step S230 so as to constitute a second light emitting layer of multi quantum well structure.

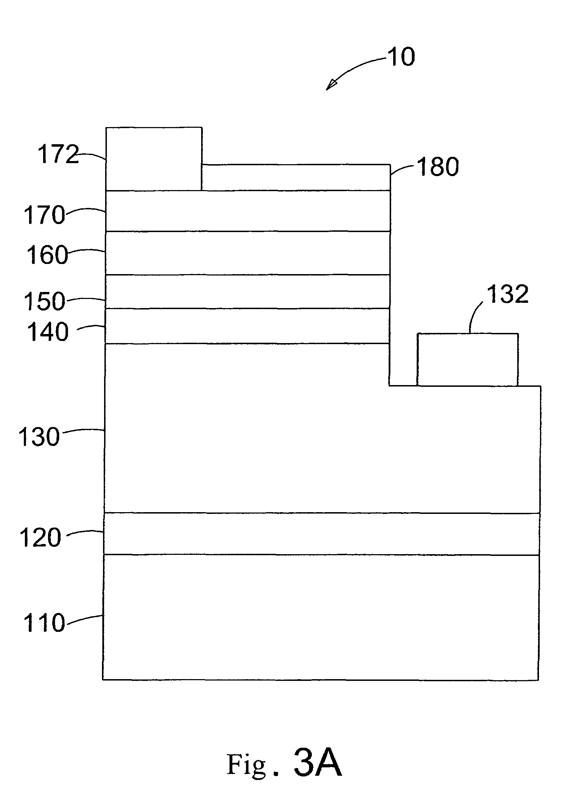

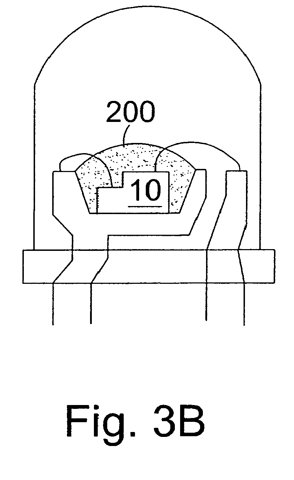

Fig. 3A and Fig. 3B are the preferred embodiment of the light emitting device structure with at least two light emitting layers and the white light emitting device structure. As shown in the figure, the white light emitting device 100 with at least two light emitting layers prominently comprises: a substrate 110, a buffer layer 120, a N-type ohmic contact layer 130, a first light emitting layer 140, a second light emitting layer 150, a cladding layer 160, a P-type ohmic contact layer 170, a P-type transparent metal conductive layer 180, a P-type electrode 172, a N-type electrode 132, and a fluorescent material 200. Wherein, the buffer layer 120 is on the substrate, the N-type ohmic contact layer 130 is with said buffer layer thereunder, the first light emitting layer 140 and the second light emitting layer 150 are on the N-type ohmic contact layer 130 sequentially. The second light emitting layer 150 is with said cladding layer 160 thereon, which is with said P-type ohmic contact layer 170 thereon. The P-type ohmic contact layer 170 is with said P-type transparent metal conductive layer 180 and P-type electrode 132 formed thereon, and part of the N-type ohmic contact layer 130 is with N-type electrode 132 thereon. Then the fluorescent material 200 is applied on the light emitting direction of the formed light emitting device as mentioned above.

Therein, the material of the buffer layer is the GaN compound, which can be AlₓGa₁₋ₓN (0≦x≦1), and the material of the N-type ohmic contact layer can be N-GaN with the impurity of the carriers of silicon. Besides, the material of the cladding layer can be P-type AlGaN (P-Al_{z}Ga_{1-z}N , z~0.2) with the impurity of Mg carrier concentration, and the P-type ohmic contact layer can be P-GaN with the impurity of Mg carriers.

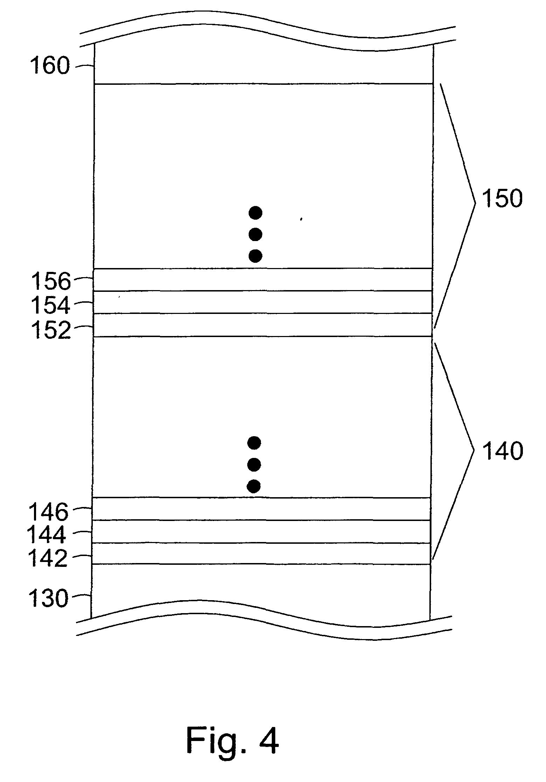

Moreover, as shown in Fig. 4, which is the preferred embodiment of the light emitting layer structure of the white light emitting device of this invention, therein the first light emitting layer 140 includes a first barrier layer 142, a first quantum well 144, and a second quantum well 146. The afore-mentioned structures repeat three to ten times interactively and constitute a first light emitting layer 140 of multi quantum well (MQW) structure. And the second light emitting layer 150 includes a second barrier layer 152, a third quantum well 154, and a forth quantum well 156. Following, the above-mentioned structures repeat three to ten times interactively and constitute a second light emitting layer 150 of multi quantum well (MQW) structure.

### Example

This invention employs an Organometallic Vapor Phase Epitaxy (OMVPE). First of all, prepare a sapphire substrate, and form a low temperature buffer layer with the thickness around 200∼300 Å on it. Subsequently, raise the growing temperature to 1025°C and form a high temperature buffer layer on the low temperature buffer layer, wherein the high temperature buffer layer is around 0.7µm in thickness. Then form a N-type ohmic contact layer on the high temperature buffer layer at the same temperature, wherein the N-type ohmic contact layer with the grown thickness about 2~5µm is N-GaN mixed with the Si carriers with the concentration around 3~5e+18 cm⁻³.

Then, form a first orange-red light emitting layer. First of all, cool the growing temperature to 800~830°C to form a GaN barrier layer with the thickness of 70∼200 Å, and then interrupt the epitaxy growing by lowering down the growing temperature to 700~730°C so as to form a first quantum well of InN with the thickness of 15~40 Å. Subsequently, form a second quantum well of InGaN(InₓGa₁₋ₓN ' x∼0.48) with the thickness of 15~40 Å and then a GaN barrier layer with the thickness of 30∼50 Å. And then interrupt the epitaxy growing and prompt the growing temperature to 800~830°C so as to repeatedly form a GaN barrier layer with the thickness of 70~200 Å. Repeat the process three to ten times so as to form a orange-red light emitting layer 205 of multi quantum well (MQW) structure, and then maintain the temperature at 750~800°C .

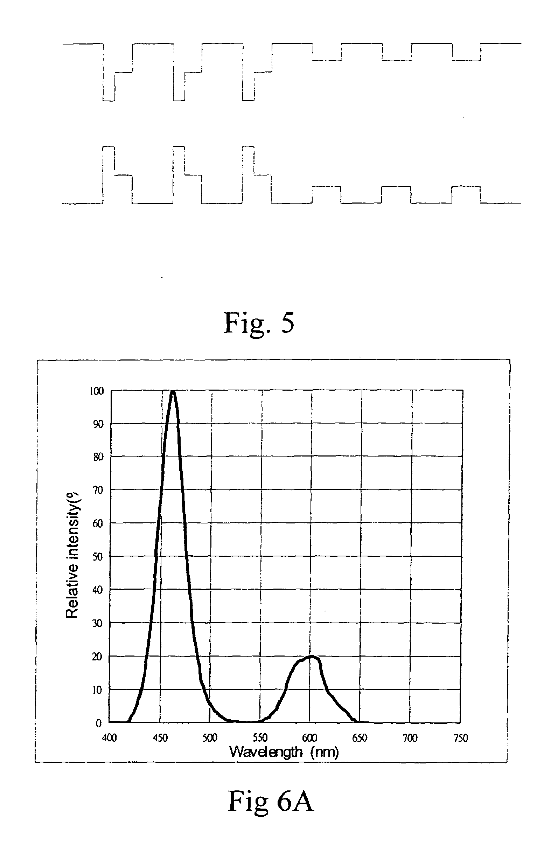

Form a second blue light emitting layer,
wherein the structure is constituted of the GaN barrier layer with the thickness of 70∼200 Å and the multi quantum well (MQW) with the thickness of 20∼30 Å formed of the InGaN (In_{y}Ga_{1-y}N , y~0.24) repeat three to ten times. As shown in Fig. 5, which is the preferred embodiment of this invention, wherein, the first orange-red light emitting layer and the second blue light emitting layer constitute a simple energy band.

After finishing the light emitting layer, prompt the growing temperature to 930~980°C and form a P-type AlGaN cladding layer (P-Al_{z}Ga_{1-z}N _{'} z~0.2) , doped with the Mg carriers at the concentration around 3e+17~5e+19 cm⁻³, with the thickness of 200~500Å and a P-GaN ohmic contact layer, doped with the Mg carriers at the concentration of 3e+18~1e+20 cm⁻³, with the thickness of 1000~5000Å on the last barrier layer of the light emitting layer.

After finishing the afore-mentioned epitaxy growing, remove a part of the P-type ohmic contact layer, cladding layer, light emitting layer, and N-type ohmic contact layer by dry etching to expose the surface of the N-type ohmic contact layer. Then proceed an evaporation process so as to form a P-type transparent metallic conductive layer on the P-type ohmic contact layer, and then form a P-type electrode on the P-type transparent metallic conductive layer and a N-type electrode on the N-type ohmic contact layer.

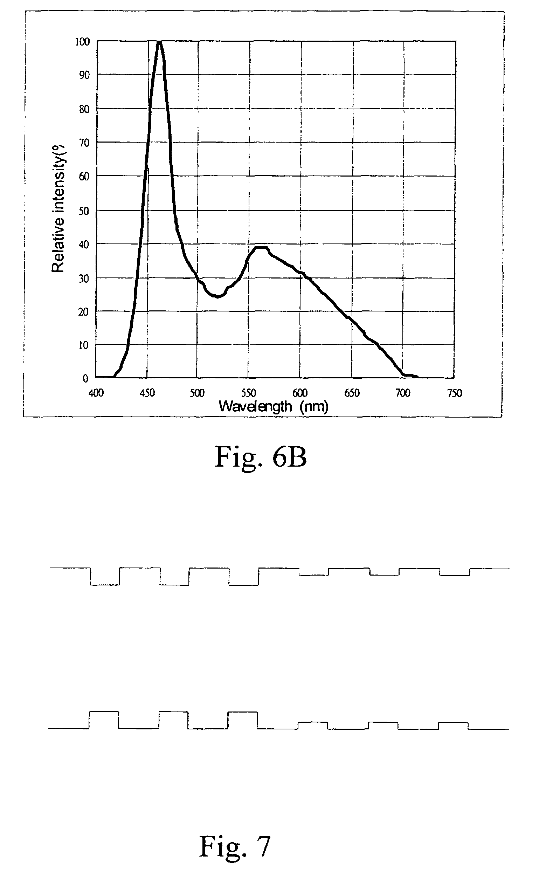

Subsequently, the epiwafer is lapping and dicing into the light emitting diode chip at the size around 380X320µm². While imposing the driving current of 20mA to the P-type electrode and N-type electrode, the light emitting spectrum, as shown in fig. 6 A, demonstrates the main emission peak of 460nm and the sub emission peak of 630nm. Then pack the light emitting diode chip and the yttrium-aluminum-garnet (YAG) fluorescent material capable of emitting yellow-green light together to form the conventional DIP light emitting diode or SMD light emitting diode. The yttrium-aluminum-garnet (YAG) fluorescent material, generally presented as the formula of (YₓGd₁₋ₓ)(Al_{y}Ga_{1-y})₅O₁₂:Ce, with the yellow-green light can constitute the white light after being imposed with the driving current of 20mA. Therein, the light emitting spectrum is shown in Fig. 6B, and the rendering index can achieve 90. In addition to the afore-mentioned YAG fluorescent material, the fluorescent material can also be TAG (terbium aluminum garnet) with yellow-green light, generally represented as the formula of Tb₃Al₅O₁₂:Ce³⁺, or STG with yellow-green light, represented as the formula of SrGa₂S₄:Eu ²⁺

It is another embodiment of this invention to form the GaN compounds by employing organometallic vapor phase epitaxy(OMVPE). At first, prepare a sapphire, and form a low temperature buffer layer with the thickness of 200~300 Å on the surface of said substrate at the temperature around 500 °C . Then prompt the growing temperature to 1025°C . At such high temperature, form a high temperature buffer layer with the thickness around 0.7µm on the low temperature buffer layer. Subsequently, form a N-type ohmic contact layer on said high temperature buffer layer, wherein the N-type ohmic contact layer with the thickness around 2~5µm is N-GaN mixed with Si carriers at the concentration around 3~5e+18 cm⁻³.

Then form a first blue light emitting layer. Firstly, lower down the temperature to 750~800°C to form a GaN barrier layer with the thickness around 70∼200 Å, and then form a InGaN (InₓGa₁₋ₓN , x∼0.24) quantum well 305b with the thickness around 20∼30 Å. Repeat the process 3~10 times so as to form a first blue light emitting layer of multi quantum well (MQW) structure.

Then prompt the temperature to 840~890°C to form a second UV light emitting layer of the structure of multi quantum well (MQW) made of 3∼10 times interactively repeat of the GaN barrier layer with the thickness around 70∼200 Å and InGaN (In_{y}Ga_{1-y}N ' y~0.08). As shown in Fig. 7, which is the preferred embodiment of this invention, wherein the first blue light emitting layer and the second UV light emitting layer form a simple energy band.

After finishing the light emitting layer, prompt the temperature to 930~980°C and form a P-type AlGaN cladding layer with the thickness of 200~500Å, mixed with Mg carriers at the concentration of 3e+17~5e+19 cm⁻³ on the last barrier layer of the light emitting layer. Upon completing the above-mentioned epitaxy growing, remove a part of said P-type ohmic contact layer, cladding layer, light emitting layer, and N-type ohmic contact layer by dry etching to expose the surface of the N-type ohmic contact layer.

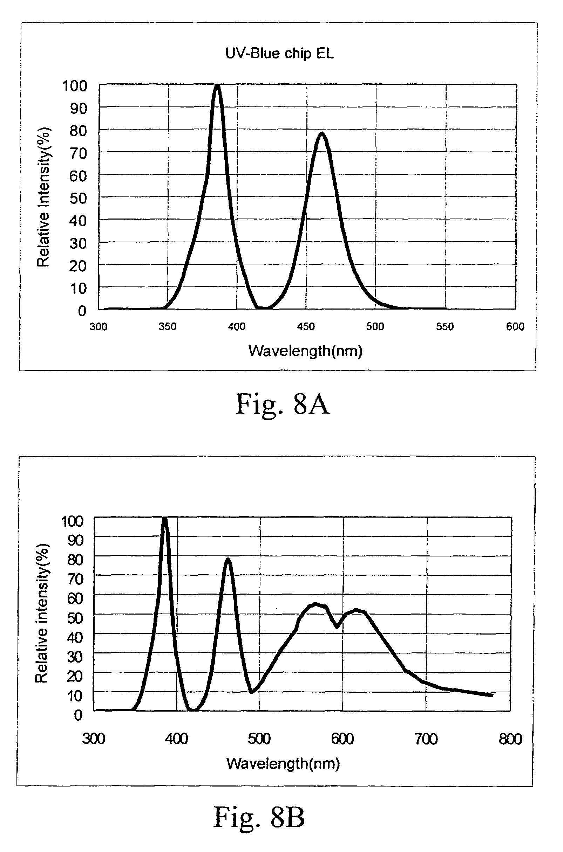

Following, the epi wafer is lapping and dicing into the light emitting diode chip at the dimension around 380X320µm². While imposing the driving current of 20mA to the P-type and N-type electrode, the light emitting spectrum is shown as Fig. 8A, wherein the main emission peak is -380nm and the sub emission peak is ∼460nm. Then the yttrium-aluminum-garnet (YAG) fluorescent material capable of emitting yellow-green light and yttrium oxide fluorescent material of red light are applied to said light emitting diode chip so as to pack the conventional DIP light emitting diode or SMD light emitting diode. While imposing the driving current of 20mA, the mixed white light, shown as Fig. 8B, is available. In general, the yttrium-aluminum-garnet (YAG) fluorescent material capable of emitting yellow-green light is represented as the formula of (YₓGd₁₋ₓ)(Al_{y}Ga_{1-y}) ₅O₁₂:Ce, and the yttrium oxide fluorescent material of red light is represented as Y₂O₃:Eu, therein the rendering index can be as high as 92. In addition to the afore-mentioned fluorescent materials, the Tb₃Al₅O₁₂:Ce³⁺ or the SrGa₂S₄:Eu²⁺ can also be used to substitute the YAG, and the Sr₂P₂O₇:Eu, Mn, the Sulfides:Eu(AES:Eu²⁺), or the Nitrido-silicates:Eu(AE₂Si₅N₈:Eu²⁺) can be used to substitute the yttrium oxide.

In conclusion, this invention definitely achieves creativity, improvement, and more usability for the users in the industry. This being the case, it should be qualified for the patent applications in the intellectual patent regulation of our country, thus being proposed for the approval of the patent. Looking forward to the kind rendering of the approval at the earliest convenience.

The above-mentioned practice is only a preferred embodiment of this invention, not the specified limit of it. All the parallel changes and revisions of the shape, the structure, the feature, and the spirit evolving from this invention should be included in the field of the claimed patent of this invention.

## Claims

1. A white light emitting device comprising:
a light emitting diode; and
a fluorescent material applied on said light emitting diode;
wherein said light emitting diode is with at least two light emitting layers which are capable of emitting two different kind of lights with the wavelengths of λ 1 and λ 2 individually;
wherein the light of one of the wavelength is absorbed by said fluorescent material and transfer into another light of wavelength of λ 3;
wherin the relationship between the wavelengths is λ 1< λ 3< λ 2, and the white light can be formed by the mixing of these three wavelengths.

2. The white light emitting device as claimed in claim 1,
wherein said light emitting diode is made by the GaN-based compound semiconductor.

3. The white light emitting device as claimed in claim 1,
wherein the wavelength of λ 1 of said light emitting diode is with the range of 430nm ≦ λ 1 ≦ 475nm.

4. The white light emitting device as claimed in claim 1,
wherein the wavelength of λ 2 of said light emitting diode is with the range of 600nm ≦ λ 2 ≦ 650nm.

5. The white light emitting device as claimed in claim 1,
wherein the wavelength of λ 3 of said light emitting diode is with the range of 530nm ≦ λ 3 ≦ 580nm.

6. The white light emitting device as claimed in claim 1,
wherein the quantum well of one of the light emitting layer of said light emitting diode includes InN/InₓGa₁₋ₓN, and the quantum well of the other light emitting layer includes In_{y}Ga_{1-y}N with the optimal value of 0.45 <x<0.6 ^{,} 0.15<y<0.3.

7. The white light emitting device as claimed in claim 1,
wherein the substrate of said light emitting diode can be selected from the group consisting of sapphire, SiC, Si, GaAs, ZnO, ZrB₂, LiGaO₂, and LiAlO₂.

8. The white light emitting device as claimed in claim 1,
wherein the fluorescent material is selected one of yttrium aluminum garnet (YAG), (YₓGd₁₋ₓ)(AlyGa_{1-y})₅O₁₂:Ce, Tb₃Al₅O₁₂:Ce³⁺ , or SrGa₂S₄:Eu²⁺.

9. A white light emitting device comprising:
a light emitting diode; and
at least two fluorescent materials applied on said light emitting diode;
wherein said light emitting diode is with at least two light emitting layers capable of emitting lights of two different kind of wavelengths, λ 1 and λ 2, individually;
wherein said two or more fluorescent materials are capable of absorbing the light of one of the wavelength of said light emitting diode and emitting the light of another wavelengths of λ 3 and λ 4, where λ 1 < λ 2< λ 3< λ 4;
wherein the white light can be made of the mixing of the wavelengths, λ 2, λ 3, and λ 4.

10. The white light emitting device as claimed in claim 9,
wherein said light emitting diode is made by the GaN-based compound semiconductor.

11. The white light emitting device as claimed in claim 9,
wherein the wavelength of said light emitting diode is with the range of 365nm ≦ λ 1 ≦ 430nm.

12. The white light emitting device as claimed in claim 9,
wherein the wavelength of said light emitting diode is with the range of 430nm ≦ λ 2 ≦ 475nm.

13. The white light emitting device as claimed in claim 9,
wherein the wavelength of said light emitting diode is with the range of 530nm ≦ λ 3 ≦ 580nm.

14. The white light emitting device as claimed in claim 9,
wherein the wavelength of said light emitting diode is with the range of 600nm ≦ λ 4 ≦ 650nm.

15. The white light emitting device as claimed in claim 9,
wherein the quantum well of one of the two said light emitting layers is made of InₓGa₁₋ₓN, and the other one is made of In_{y}Ga_{1-y}N, where 0.15<x<0.36 and 0<=y<0.1.

16. The white light emitting device as claimed in claim 9,
wherein said fluorescent material of light emitting diode is made of the one selected from the group consisting of yttrium aluminum garnet (YAG), (YₓGd₁₋ₓ)(Al_{y}Ga_{1-y})₅O₁₂:Ce, Tb₃Al₅O₁₂:Ce³⁺ and, SrGa₂S₄:Eu²⁺, and the one selected from the group consisting of yttrium oxide(Y₂O₃:Eu), Sr₂P₂O₇:Eu,Mn, Sulfides:Eu(AES:Eu²⁺), and
Nitrido-silicates:Eu(AE₂Si₅N₈:Eu²⁺).

17. A white light emitting device manufacturing comprising the steps of:
preparing a substrate;
forming a buffer layer on said substrate;
forming a N-type ohmic contact layer on said buffer layer;
forming a first light emitting layer on said N-type ohmic contact layer;
forming a second light emitting layer on said first light emitting layer;
forming a P-type ohmic contact layer on said second light emitting layer;
forming a P-type electrode on said P-type ohmic contact layer; and
forming a N-type electrode on said N-type ohmic contact layer;
wherein the LED chip has been constituted by the above-mentioned process, and then the fluorescent material is installed on the light emitting direction of the LED chip.

18. The white light emitting device as claimed in claim 17,
wherein said first light emitting layer manufacturing method of the light emitting diode comprises the steps of:
a. forming a first barrier layer on said N-type ohmic contact layer;
b. forming a first quantum well on said barrier layer;
c. forming a second quantum well on said first quantum well; and
d. forming a second barrier layer on said second quantum well;
wherein said light emitting layer of multi quantum well structure is constituted by duplicating the process of b, c, and d.

19. The white light emitting device as claimed in claim 17,
wherein the second light emitting layer manufacturing method of light emitting diode mainly comprises the steps of:
a. forming a third barrier layer on said first light emitting layer;
b. forming a third quantum well on said barrier layer;
c. forming a forth quantum well on said third quantum well; and
d. forming a forth barrier layer on said forth quantum well;
wherein said second light emitting layer of multi quantum well structure is constituted by duplicating the process of b, c, and d.
